# EUROPEAN PATENT APPLICATION

(11) **EP 1 693 790 A1**
(43) Date of publication of application: **23.08.2006**
(21) Application number: 05013157.2
(22) Date of filing: 17.06.2005
(51) Int. Cl.: G06K 19/077, G06K 7/00

(54) **Memory card with replacable memory chip**

(30) Priority: 18.02.2005 CN 200520028280
(71) Applicant: Tzu, Chung-Hsing, Rugo 226500 Jiansu Province (CN)
(72) Inventor: Tzu, Chung-Hsing, Rugo 226500 Jiansu Province (CN)
(74) Representative: Appelt, Christian W.

(57) **Abstract**

A memory card with its memory chip replaceable as desires includes a circuit substrate (1) disposed with control chip, chip contact and golden finger thereon, and a package externally to the circuit substrate to expose the golden finger from one side of the package; the package containing a slot to accommodate a socket for one end of the conductor in the socket to conduct through the chip contact of the circuit substrate for the memory chip to be placed into the socket as desired to conduct through the socket conductor, the chip contact and the golden finger for production cost reduction and replacement of memory chip as desired.

## Description

### BACKGROUND OF THE INVENTION

### (a) Field of the Invention

The present invention is related to a memory card with chip replaceable, and more particularly, to one that can be plugged to various types of electronic products to serve as a storage unit.

### (b) Description of the Prior Art:

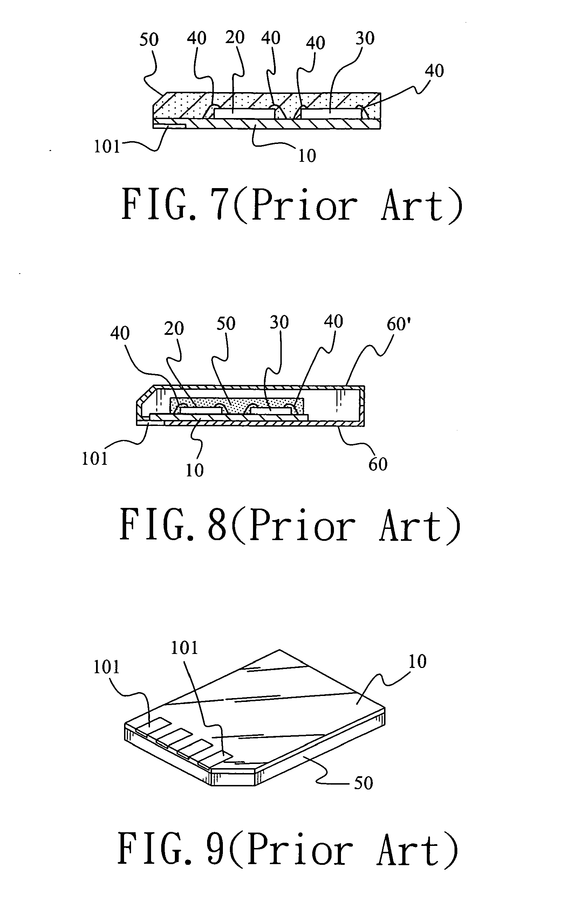

Memory cards generally available in the market including MMC, RSMMC, SD, miniSD as illustrated in Figs. 7 and 8 of the accompanying drawings usually have a circuit substrate 10, multiple external contracts 101 (the golden finger) are disposed on the edge of the circuit substrate 10, and a memory chip 20 and a control chip 30 are fixed to the selected locations on the circuit substrate 10. Multiple conductors 40 provide electric connection between the memory chip 20 and the circuit substrate 10 and where between the control chip 30 and the circuit substrate 10. Furthermore, a gel coat 50 is provided on the memory chip 20 and the control chip 30 to take advantage of the contour of the gel coat 50 to directly constitute the memory card with exposed golden finger as illustrated in Figs. 7 and 9.

Alternatively, two gel coats 60' 60' in the shape of " 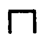 " wrap up the circuit substrate, the memory chip 20 and the control chip 30 as illustrated in Fig. 8 to expose the golden finger on the edge of the gel coat 60 to constitute a memory card functioning as a storage unit to be plugged to any type of digital electronic product.

However, the prior art of the construction of a memory card once completed with the packaging prevents replacement of the memory chip 20 as desired. As the technology advances by day, the existing memory capacity or storage/retrieve rate fails to meet higher demands by the user or if the memory chip is found defective, the entire memory card must be waived and the purchase of a new memory card is required to cause extra financial burden to the user.

### SUMMARY OF THE INVENTION

The primary purpose of the present invention is to provide a memory card with its memory chip replaceable to improve the construction of the memory card for allowing replacement of the memory chip as desired and for further reduction of service and upgrade.

To achieve the purpose, the present invention is comprised of a circuit substrate, a package, and a socket. Wherein, control chip, chip contacts and golden finger are provided on the selected locations on the surface of the circuit substrate. The package is made of encapsulant integrated in one piece on the circuit substrate, or of two gel coats wrapping up the circuit substrate. The golden finger of the circuit substrate is exposed out of the outer edge of the package. A slot is disposed in the package to accommodate the chip contacts of the circuit substrate. The socket is fixed to the slot in the package and includes a base and a lid. A conductor is disposed in the base with one end of the conductor to connect through the chip contacts of the circuit substrate. Accordingly, the memory chip can be placed into the socket as desired to connect through the conductors of the socket, the chip contacts and the golden finger to achieve the purposes of cost savings and replacement of updated memory chip.

### BRIEF DESCRIPTION OF THE DRAWINGS

Fig. 1 is a perspective view of a memory card packaged with encapsulant of the present invention.
Fig. 2 is a sectional view of the memory card packaged with encapsulant of the present invention.
Fig. 3 is a perspective view of a memory card packaged with two gel coats.
Fig. 4 is a sectional view of the memory card packaged with two gel coats.
Fig. 5 is a perspective view of another preferred embodiment of the present invention.
Fig. 6 is a sectional view of another preferred embodiment of the present invention.
Fig. 7 is a schematic view of a memory card packaged with encapsulant of the prior art.
Fig. 8 is a schematic view showing a memory card packaged with two gel coats of the prior art.
Fig. 9 is a schematic view showing the appearance of a memory card of the prior art.

### DETAILED DESCRIPTION OF THE PREFERRED EMBODIMENTS

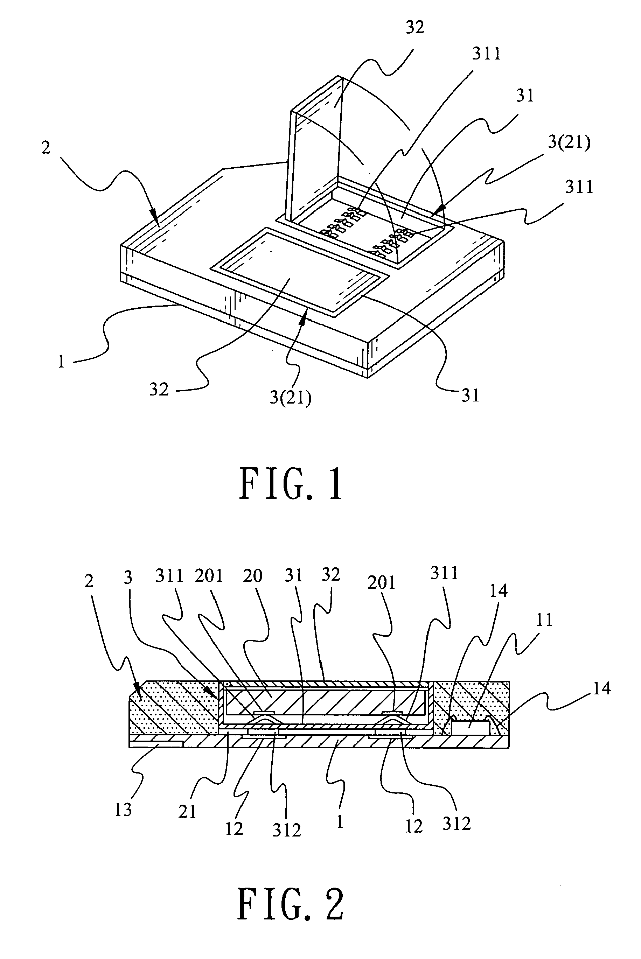

Referring to Figs. 1 through 4, a memory card with chip replaceable of the present invention related to a storage unit that is plugged to various types of electronic products and permits replacement of a memory chip in the memory card is essentially comprised of a circuit substrate 1, a package 2 (2A) and a socket 3.

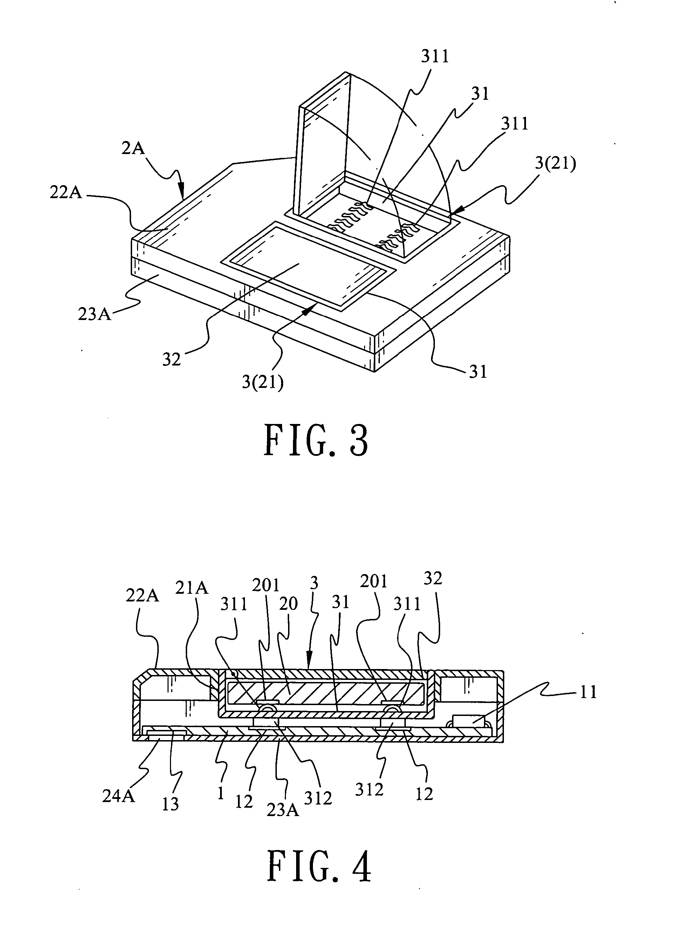

Wherein, the circuit substrate 1 as illustrated in Figs. 2 and 4 is related to a circuit board; at the selected locations on the surface are disposed with a control chip 11, circuitry, electronic devices (including active and passive devices), and multiple chip contacts 12; and multiple external contacts (known as the golden finger) are provided to the edge of the opposite surface. The control chip 11 is related to a naked chip as illustrated in Fig. 2, or a packaged chip as illustrated in Fig. 4 soldered to the circuit substrate 1, that is fixed to the circuit substrate 1 and multiple metal conductors 14 are electrically connected to where between the control chip 11 and the circuit substrate 1. Those multiple contacts 12 are related to multiple circuit contracts that can be conducted on the surface of the circuit substrate 1.

The package 2 (2A) as respectively illustrated in Figs. 1 and 2 is comprised of an encapsulant integrated with the control chip 11 and the chip contacts 12 of the circuit substrate 1 so to expose the golden finger 13. An accommodation slot 21 is defined in the package 2 in relation to those multiple contacts 12 for the latter to be placed on the bottom of the accommodation slot 21. Alternatively as illustrated in Figs. 3 and 4, the package 2 is comprised of two gel coats 22A, 23A (ultrasonic infused) wrapping up the circuit substrate 1. The gel coat 22A is disposed with an accommodation slot 21 A in relation to those chip contacts 12 so that those chip contacts 12 is placed on the bottom of the accommodation slot 21. A hollowed space 24A is provided to another gel coat 23A to expose the golden finger of the circuit substrate 1 to engage in electricity connection with other digital electronic product.

As illustrated in Figs. 2 and 4, the socket 3 fixed in the accommodation slot 21 (21 A) of the package 2 (2A) includes a base 31 and a lid 32. The base 31 relates to a recessed gel coat provided at its bottom multiple conductors 311 (conductive materials including metal clip, metal block or tin ball) and a conduction part 312 extends from each conductor 311 on the bottom of the base to electrically connect those contacts 12 on the circuit substrate 1 (either by soldering or by elastic contact). The lid is related to a plate pivoted to the base 31 to open or close the base 31.

When assembled, the circuit substrate 1, the package 2 (2A) and the socket 3 constitute a memory card with chip replaceable. The user may open up the lid 32 of the socket 3 as illustrated in Figs. 1 and 3 to put a package memory chip 20 into the socket for the memory chip 20 to contact the conductor 311 by means of a contact 201 comprised of a conductor arm or a circuit board, and further to be conducted with the control chip 11, those chip contacts 12 and the golden finger 13 of the circuit substrate 1 for the memory card to be plugged to various types of electronic products to function as a storage unit. Accordingly, the memory chip 20 can be replaced and upgraded as desired to achieve the reduction of upgrade and service costs.

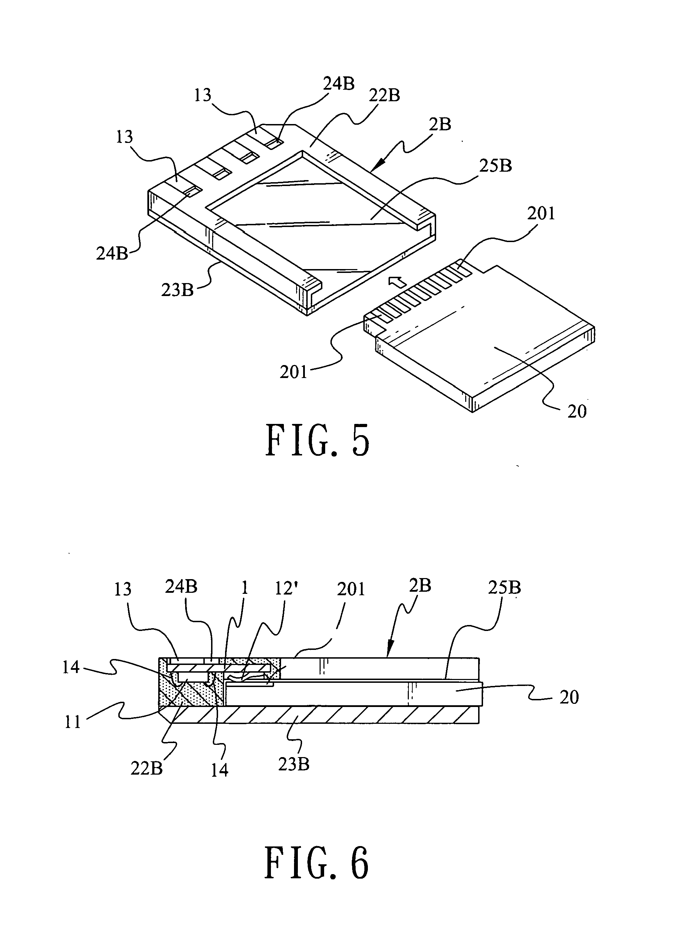

As illustrated in Figs. 5 and 6, a chip contact 12' of the circuit substrate 1 is fixed to a contact metal clip structure provided on the circuit substrate 1 and is wrapped up by a package 2B externally provided to the circuit substrate 1; a lateral slot 25B and a hollowed space 24B to expose the golden finger 13 of the circuit substrate 1 thereof are provided in the package 2B; and the chip contact 12' of the contact metal clip construction extends into the lateral slot 25B to form a memory card with its memory chip 20 replaceable for the contact 201 of the memory chip 20 to be conducted with the chip contact 12' of the circuit substrate 1. The package 2B is comprised of an encapsulant integrated in one piece or two gel coats 22B, 23B.

The memory card with its memory chip replaceable of the present invention is practical and innovative with a novel operation of its means and results reasonably and significantly compliant with its purposes of design; therefore, this application for a utility patent is duly filed.

## Claims

1. A memory card with its memory chip replaceable includes:
a circuit substrate disposed with control chip, circuitry, electronic device and multiple chip contacts thereon and multiple external contacts on the edge on the opposite side of the circuit substrate;
a package, made of encapsulant made integrated into one piece on the side of the circuit substrate where the control chip and the chip contacts to expose the golden finger of the circuit substrate, a slot being provided in the package at where in relation to the chip contacts, and the chip contacts being placed at the bottom of the slot; and
a socket fixed to the slot in the package being comprised of multiple conductors to conduct through the memory chip with each conductor having an extension to engage in electric connection with the chip contacts of the circuit substrate.

2. The memory card with its memory chip replaceable of Claim 1, wherein the package is comprised of two gel coats bound to each other and wrapping up both sides of the circuit substrate; a gel coat being provided with a slot in relation to the chip contacts; the chip contacts being placed on the bottom of the slot; the other gel coat being provided with a hollowed space to expose the golden finger of the circuit substrate thereon.

3. The memory card with its memory chip replaceable of Claim 1, wherein the socket includes a base and a lid; the base relating to a recessed gel coat containing multiple conductors; the conductor having an extension to reach the bottom of the base to engage in electric connection with the chip contact of the circuit substrate; and the lid being pivoted to the base to open or close the base.

4. The memory card with its memory chip replaceable of Claim 1, wherein the control chip of the circuit substrate is comprised of a naked chip fixed thereto and multiple metal conductors to electrically connect between the control chip and the circuit substrate; alternatively, the control chip being related to a package chip soldered to the circuit substrate; and the chip contacts being comprised of multiple conductive contacts disposed on the surface of the circuit substrate.

5. A memory card with its memory chip replaceable includes:
a circuit substrate disposed with control chip, circuitry, electronic device and conduction metal clip comprised of multiple chip contacts and multiple external contacts on the edge on the opposite side of the circuit substrate;
a package wrapping up the circuit substrate, a lateral slot disposed in the package, and a hollowed space to expose the golden finger of the circuit substrate; multiple chip contacts in the shape of conduction metal clip extending into the lateral slot; a memory chip being inserted into the lateral slot of the package as desired; and the memory card achieving electric connection between those multiple chip contacts and the memory chip.
